# EUROPEAN PATENT APPLICATION

(11) **EP 3 992 863 A1**
(43) Date of publication of application: **04.05.2022**
(21) Application number: 21199423.1
(22) Date of filing: 28.09.2021
(51) Int. Cl.: G06N 3/063, G06N 3/04, G06F 9/50

(54) **METHOD AND DEVICE WITH DEEP LEARNING OPERATIONS**

(30) Priority: 02.11.2020 KR 20200144563
(71) Applicant: Samsung Electronics Co., Ltd., Suwon-si, Gyeonggi-do 16677 (KR); Industry-Academic Cooperation Foundation, Yonsei University, Seoul 03722 (KR)
(72) Inventor: Kwon, Hyung-dal, Suwon-si, Gyeonggi-do (KR); Kim, Youngsok, Seoul (KR); Lee, Jounghoo, Seoul (KR); Choi, Jin Woo, Seoul (KR)
(74) Representative: Grünecker Patent- und Rechtsanwälte PartG mbB

(57) **Abstract**

A method and a device with deep learning operations. An electronic device includes a processor configured to simultaneously perform, using a systolic array, a plurality of tasks, wherein the processor includes the systolic array having a plurality of processing elements (PEs), and a first on-chip network that performs data propagation between two or more of the plurality of PEs, where each of the plurality of tasks includes one or more deep learning operations.

## Description

### BACKGROUND

### 1. Field

The following description relates to a method and a device with deep learning operations.

### 2. Description of Related Art

A computational architecture implementing a neural network typically requires a large amount of computational operation for complex input data, for analyzing a large amount of input data, and/or for extracting and/or other solutions with respect to desired information, as non-limiting examples.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, an electronic device includes a processor configured to simultaneously perform, using a systolic array, a plurality of tasks, wherein the processor includes the systolic array having a plurality of processing elements (PEs), and a first on-chip network that performs data propagation between two or more of the plurality of PEs, where each of the plurality of tasks includes one or more deep learning operations.

The processor may be configured to distribute the plurality of PEs to simultaneously perform respective deep learning operations of a plurality of neural networks (NNs), where the distribution of the plurality of PEs may be performed based on characteristics of the plurality of NNs.

The distribution of the plurality of PEs may include a distribution of all PEs of the systolic array.

The processor may be configured to set, based on characteristics of a plurality of NNs, respective propagation directions of input data and corresponding output partial sums.

The processor may be configured to divide a NN into a plurality of sub-NNs and distribute the plurality of PEs so as to simultaneously perform deep learning operations of the sub-NNs.

The processor may be configured to set respective propagation directions of input data and corresponding output partial sums based on characteristics of the sub-NNs.

The processor may further include an input data transfer module configured to input data to different sides of the systolic array.

The different sides of the systolic array may be opposing left and right sides of the systolic array, and the input data transfer module may further include a first systolic data setup module configured to adjust a timing for inputting first input data to the left side of the systolic array and transfer first input data to the left side of the systolic array, a second systolic data setup module configured to adjust a timing for inputting second input data to the right side of the systolic array, and a second on-chip network configured to transfer the second input data to the right side of the systolic array.

The different sides of the systolic array may be opposing left and right sides of the systolic array, where first input data is input using the first on-chip network and second input data is input using a second-one-chip network, and the processor may further include another input data transfer module configured to input weight input data to upper and lower sides of the systolic array, wherein the other input data transfer module may include a weight buffer configured to adjust a timing for inputting first weight input data and second weight input data to the systolic array, and to transfer the first weight input data to respective first PEs through the upper side of the systolic array, and a third on-chip network configured to transfer the second weight input data to respective second PEs, of the plurality of PEs, through the lower side of the systolic array.

The processor may further include an input data transfer module configured to input input data to upper and lower ends of respective PEs of the plurality of PEs.

The input data transfer module may include a weight buffer configured to adjust a timing for inputting at least first weight input data to first PEs, of the plurality of PEs, and transfer the first weight input data to upper ends of the first PEs, and another on-chip network configured to transfer second weight input data to lower ends of second PEs of the plurality of PEs.

The weight buffer may be configured to adjust the timing for inputting the second weight input data to the second PEs.

The processor may further include an output data receiving module configured to receive output data corresponding to a result of an operation, between first input data and second input data, from upper and lower sides of the systolic array.

The output data receiving module may include output accumulators, and another on-chip network configured to transfer corresponding output partial sums propagated to the upper side of the systolic array to a lower end of the output accumulators, and transfer corresponding output partial sums propagated to the lower side of the systolic array to an upper end of the output accumulators.

In one general aspect, a processor-implemented method may include determining whether a first neural network (NN) is presently being run by a processor, and, in response to the first NN being determined to be presently run by the processor, distributing a plurality of processing units (PEs) to simultaneously perform a deep learning operation of the first NN and a deep learning operation of a second NN based on a characteristic of the first NN and a characteristic of the second NN, wherein the second NN is a NN newly set to be run by the processor, setting respective propagation directions of input data and corresponding output partial sums based on the characteristic of the first NN and the characteristic of the second NN, and simultaneously performing the deep learning operation of the first NN and the deep learning operation of the second NN using the distributed plurality of PEs.

The distributing of the plurality of PEs may include determining a distribution method and a distribution ratio of the plurality of PEs based on the characteristic of the first NN and the characteristic of the second NN.

The distributing of the plurality of PEs may include preempting a presently run deep learning operation of the first NN based on the distribution method and the distribution ratio, and
implementing the distributing of the plurality of processing units (PEs) by allocating multiple PEs, of the plurality of PEs, secured through the preempting to perform the deep learning operation of the second NN, and allocating another multiple PEs, of the plurality of PEs, secured through the preempting to perform the deep learning operation of the first NN.

The plurality of PEs may be PEs of a systolic array.

The method may further include determining, in a case in which the first NN is not presently being run by the processor, whether the second NN has a plurality of batches, and, in response to the second NN being determined to have the plurality of batches, dividing the second NN into a plurality of sub-NNs, distributing multiple PEs, of the plurality of PEs, to simultaneously perform deep learning operations of the sub-NNs based on characteristics of the sub-NNs, setting respective propagation directions of input data and corresponding output partial sums based on the characteristics of the sub-NNs, and simultaneously performing respective deep learning operations of the sub-NNs using the distributed multiple PEs.

The distributing of the multiple PEs may include determining a distribution method and a distribution ratio of the multiple PEs based on the characteristics of the sub-NNs.

The method may further include dividing the second NN into a plurality of sub-NNs according to respective batches of the second NN, distributing multiple PEs, of the plurality of PEs, to simultaneously perform deep learning operations of the sub-NNs based on characteristics of the sub-NNs, setting respective propagation directions for input data of the multiple PEs and for output partial sums of the multiple PEs based on the characteristics of the sub-NNs, and simultaneously performing respective deep learning operations of the first NN and deep learning operations of the sub-NNs using the distributed multiple PEs.

In one general aspect, one or more embodiments may include a computer-readable recording medium having instructions, which when executed by any of the processing hardware described herein, configures the processing hardware to implement any one, combination, or all operations or methods described herein.

In one general aspect, an electronic device for performing a deep learning operation includes a processor having a systolic array including a plurality of processing elements (PEs), and a first on-chip network that performs data propagation between the plurality of PEs, wherein the processor is configured to divide a NN into a plurality of sub-NNs and distribute multiple PEs, of the plurality of PEs, so as to simultaneously perform deep learning operations of two or more of the sub-NNs.

The division of the NN into the plurality of sub-NNs may be performed according to respective tasks of different layers of the NN.

The division of the NN into the plurality of sub-NNs may be performed according to different batches of the NN.

The processor may be configured to set respective propagation directions of input data and corresponding output partial sums for the multiple PEs based on characteristics of the two or more sub-NNs.

The distribution of the multiple PEs may include determining a distribution method and a distribution ratio of the multiple PEs based on the characteristics of the sub-NNs.

The processor may be further configured to perform a deep learning operation of another NN, using other PEs of the plurality of PEs, simultaneously with the deep learning operations of the two or more of the sub-NNs performed using the multiple PEs.

Other features and aspects will be apparent from the following detailed description, the drawings, and the claims.

### BRIEF DESCRIPTION OF THE DRAWINGS

FIG. 1A is a diagram illustrating a deep learning operation method using a neural network (NN).
FIG. 1B is a diagram illustrating a filter and data of an input feature map provided as an input in a deep learning operation.
FIG. 1C is a diagram illustrating a process of performing a convolution operation based on deep learning.
FIG. 1D is a diagram illustrating a method of performing a convolution operation using a systolic array.
FIG. 2A is a diagram illustrating a method of implementing temporal multitasking based on a priority of a plurality of NNs on a systolic array.
FIG. 2B is a diagram illustrating an example of an operation of a deep learning operation device that supports spatial multitasking.
FIGS. 3A and 3B are diagrams illustrating example spatial multitasking operation methods.
FIG. 4 is a diagram illustrating an example of processing hardware of a deep learning operation device that performs a plurality of deep learning operations simultaneously.
FIGS. 5A through 5F are diagrams illustrating an example of a detailed operation performing process of a deep learning operation device.
FIG. 6 is a flowchart illustrating a method of performing deep learning operations through spatial multitasking.
FIG. 7 is a diagram illustrating an example of a method of utilizing a neural processing unit (NPU) for spatial multitasking.

Throughout the drawings and the detailed description, unless otherwise described or provided, the same drawing reference numerals will be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, some descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

Although terms of "first" or "second" are used to explain various components, the components are not limited to the terms. These terms should be used only to distinguish one component from another component. For example, a "first" component may be referred to as a "second" component, or similarly, and the "second" component may be referred to as the "first" component within the scope of the right according to the concept of the present disclosure.

It will be understood that when a component is referred to as being "connected to" another component, the component can be directly connected or coupled to the other component, or intervening components may be present.

As used herein, the singular forms "a," "an," and "the" are intended to include the plural forms as well, unless the context clearly indicates otherwise. It should be further understood that the terms "comprises" and/or "comprising," when used in this specification, specify the presence of stated features, integers, operations, elements, components or a combination thereof, but do not preclude the presence or addition of one or more other features, integers, operations, elements, components, and/or groups thereof. The use of the term "may" herein with respect to an example or embodiment (e.g., as to what an example or embodiment may include or implement) means that at least one example or embodiment exists where such a feature is included or implemented, while all examples are not limited thereto.

Unless otherwise defined herein, all terms including technical or scientific terms used herein have the same meaning as commonly understood by one of ordinary skill in the art to which examples belong based on an understanding of the disclosure of this application. It will be further understood that terms, such as those defined in commonly-used dictionaries, should be interpreted as having a meaning that is consistent with their meaning in the context of the relevant art and the disclosure of this application and will not be interpreted in an idealized or overly formal sense unless expressly so defined herein.

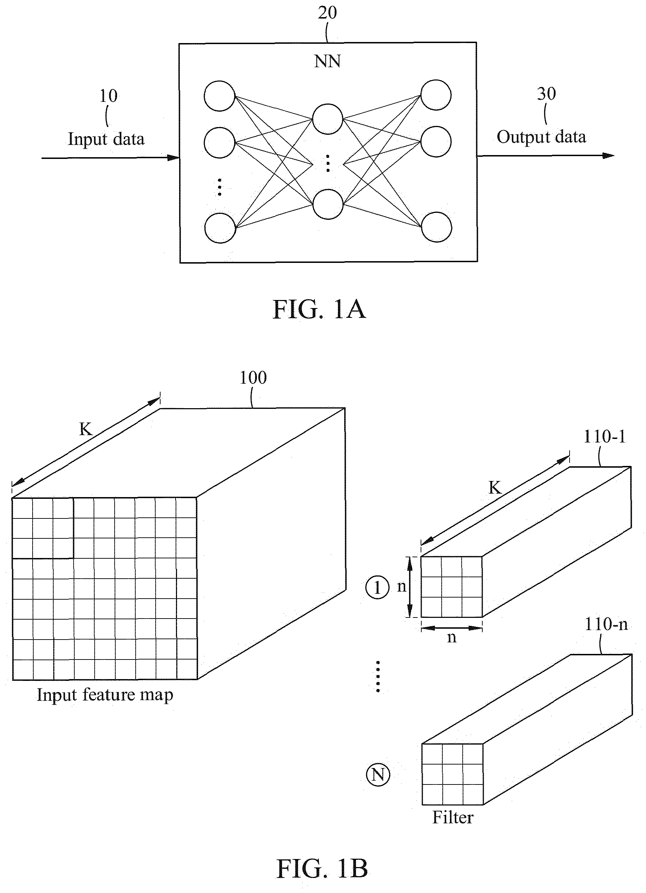

FIG. 1A is a diagram illustrating a deep learning operation method using a neural network (NN).

An artificial intelligence (Al) model with deep learning operations, as a non-limiting example, may be characterized in that input data 10 is input to the model, and output data 30 is an example output of the model. For example, the model with deep learning operations may be implemented as a neural network (NN) that has been trained, e.g., through deep learning, to generate output data 30 that is output dependent on one or more convolution operations of the NN. These convolution operations may also be referred to as inference operations. The NN that has been trained may have been trained through deep learning for a particular purpose, such as for face recognition based on feature extraction by the NN, or trained for various other purposes. The NN may alternatively be an interim NN that is being incrementally trained through deep learning, such as based on output losses, costs, or errors dependent on convolution operations of the interim NN for training inputs in a supervised training, and/or through an unsupervised training that may or may not include such corrective information derived from the outputs from the interim NN. As noted, whether as a NN that has been trained or such an interim NN, for training of the NN, deep learning operations may be performed by each of the NN that has been trained and the interim NN. In the NN, nodes of one layer are connected, such as through weighted connections, to nodes of another layer, and thereby collectively operate to process input data, for example. Various types of neural networks may include, for example, a convolutional neural network (CNN), a recurrent neural network (RNN), a deep belief network (DBN), and/or a restricted Boltzmann machine (RBM) model, and various combinations of the same, noting that examples are not limited thereto. In a feed-forward neural network, for example, each node of one layer of the neural network may have such trained connections to each node in another layer, while noting that a trained feed-forward neural network may have some zeroed or removed connections based on pruning or other training techniques. Such trained connections may extend layer-wise through the neural network in one direction, for example, in a forward direction for the feed forward neural network, in a forward and a recurrent direction in RNNs or in NNs with other feedback links, and in a forward and skipped direction for NNs with layer skipping, etc., as non-limiting examples.

For example, FIG. 1A illustrates a structure in which the input data 10 is input to the example NN (e.g., a CNN 20) and the output data 30 is output from the NN, where the NN includes one or more layers. The NN may be, for example, a deep neural network including two or more layers. In addition, the reference to the example CNN 20 is a reference to the one or more processors and/or deep learning operation devices, represented by the CNN 20, configured to implement the CNN 20.

As non-limiting examples, the CNN 20 may be configured to extract "features" such as borders, lines, and colors, as from the input data 10. The CNN 20 may include a plurality of layers, e.g., including a plurality of convolution layers. Each of the layers may receive data and generate data to be output from the corresponding layer to a next layer of the CNN 20. For example, the generated data to be output from a particular layer may be a feature map generated by performing a convolution operation between an image or feature map input to the CNN 20 and respective weights of one or more filters, also referred to as 'kernels'. In an example, one or more initial layers of the CNN 20 may be convolution layer(s) configured to extract low-level features such as edges or gradients for an image input (e.g., input data 10) to the CNN 20, and each of plural subsequent layers of the CNN 20 may be convolution layers configured to extract gradually more complex features, such as feature information of eyes and a nose included in the input image.

FIG. 1B is a diagram illustrating a filter and data of an input feature map provided as an input in a deep learning operation.

Referring to FIG. 1B, an input feature map 100 may be a set of numerical data or pixel values of an image input to a NN but is not limited thereto. Thus, as only an example, in FIG. 1B, the elements of the input feature map 100 may be pixel values of an image. For example, the input feature map 100 may have 256x256 pixels and a depth of K (e.g., K channels of an input image or output feature map of a previous layer). However, it is merely an example, and a pixel size of the input feature map 100 is not limited to the example.

Filters 110-1 to 110-n may be N filters. Each of the plurality of filters 110-1 to 110-n may include a weight of n by n (e.g., n×n). For example, each of the plurality of filters 110-1 to 110-n may have 3x3 pixels and a depth of K (e.g., K channels). However, it is merely an example, and a size of each of the filters 110-1 to 110-n is not limited to the example, however, as noted in this example the depth K of each of the filters 110-1 to 110-n may be the same as the depth K of the input feature map 100.

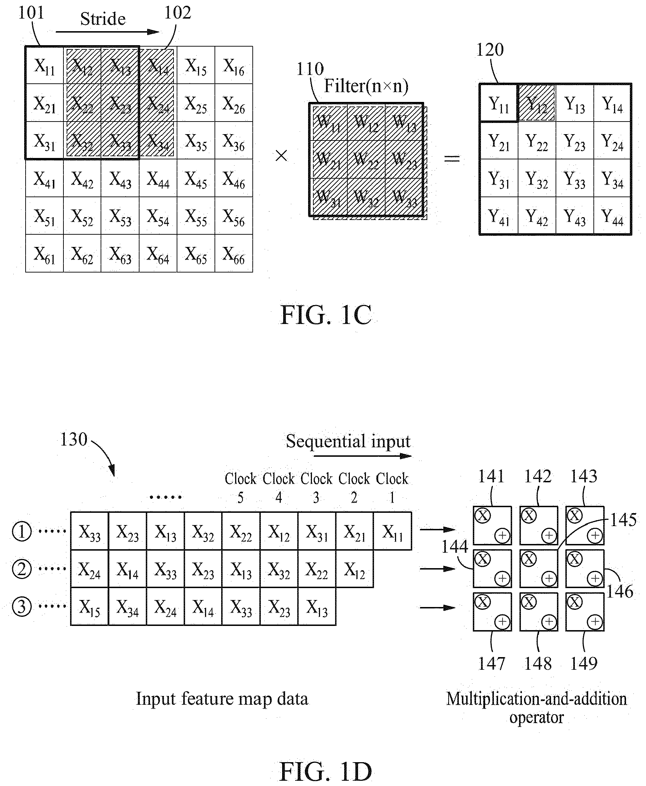

FIG. 1C is a diagram illustrating a process of performing a convolution operation based on deep learning.

Referring to FIG. 1C, a process of performing a convolution operation in a NN may involve processes of generating output values through multiplication-and-addition operations between the input feature map 100 and a filter 110, in a respective depth (or channel) of the input feature map 100 and the filter 110, and accumulating and adding up the output values, thereby generating an output feature map 120, e.g., generating an output channel of the output feature map 120.

The convolution operation performing process may be a process of performing the multiplication-and-addition operation by applying the filter 110 of a predetermined size, that is, the size of n×n from a left upper end to a right lower end of the input feature map 100, e.g., rasterizing, scanning, or stepping the filter 110 across the input feature map 100, dependent on a set stride of the convolution operation. Hereinafter, a description is given of a process of performing a convolution operation when the filter 110 has a size of 3x3.

For example, in a first area 101 of a left upper portion of the input feature map 100, an operation of multiplying nine (=3x3) data x11 to x33 including three data in a first direction and three data in a second direction by weights w11 to w33 of the filter 110 may be performed. Thereafter, output values, for example, x11*w11, x12*w12, x13*w13, x21*w21, x22*w22, x23*w23, x31*w31, x32*w32, and x33*w33 of the multiplication operation may be accumulated and added up, whereby (1-1)-th output data y11 of the output feature map 120 is generated.

After that, an operation may be performed while moving, shifting, or stepping from the first area 101 of the left upper portion of the input feature map 100 to a second area 102 by a unit of data. In this instance, the number by which data moves in the input feature map 100 in the convolution operation process may be referred to as the "stride." Based on a size of the stride, a size of the output feature map 120 to be generated may be determined. For example, when the stride is 1, (1-2)-th output data y12 of the output feature map 120 may be generated by performing an operation of multiplying nine input data x12 to x34 included in the second area 102 by the weights w11 to w33 of the filter 110 and accumulating and adding up output values, x12*w11, x13*w12, x14*w13, x22*w21, x23*w22, x24*w23, x32*w31, x33*w32, and x34*w33 of the multiplying operation. Similarly, an operation of multiplying nine input data x13 to x35 included in a next area by the weights w11 to w33 of the filter 110 may be performed and results accumulated to generate Y13, then an operation of multiplying nine input data x14 to x36 included in a next area by the weights w11 to w33 of the filter 110 may be performed and results accumulated to generate Y14. Because the example stride is 1, the output Y21 may be generated by shifting application of the filter 110 down a row, and thus, in this manner the remaining multiplications and accumulations are performed according to the stride until all outputs Y11 through Y44 have been generated. Similarly, when the input data has an additional channel or depth, a corresponding depth or channel of the filter 110 is likewise applied to the additional channel or depth of the input data and the value of each of Y11 through 44 is also dependent on the similar application of the corresponding depth or channel of the filter 110 to the additional channel or depth of the input data. When there are one or more additional filters 110, each similarly applied additional filter 110 to the input data generates a corresponding additional output depth or channel of the output feature map 120 for the input data.

FIG. 1D is a diagram illustrating a method of performing a convolution operation using a systolic array.

Referring to FIG. 1D, each data of an input feature map 130 may be mapped to a systolic array input to processing elements (PEs), for example, a first PE 141 to a ninth PE 149 sequentially based on a clock having a predetermined latency. The PE may be a multiplication-and-addition operator. As a non-limiting example, the sequential input of each input feature map may also apply to any of the below discussed systolic arrays, for each division of the PEs of the systolic arrays to perform different NN operations.

At a first clock, (1-1)-th data x11 of a first row ① of a systolic array may be input to the first PE 141. The (1-1)-th data x11 may be multiplied by the weight w11 at the first clock. At a second clock, the (1-1)-th data x11 may be input to the second PE 142, (2-1)-th data x21 may be input to the first PE 141, and (1-2)-th data x12 may be input to the fourth PE 144. Likewise, at a third clock, the (1-1)-th data x11 may be input to the third PE 143, the (2-1)-th data x21 may be input to the second PE 142, and the (1-2)-th data x12 may be input to the fifth PE 145. At the third clock, (3-1)-th data x31 may be input to the first PE 141, (2-2)-th data x22 may be input to the fourth PE 144, and (1-3)-th data x13 may be input to the seventh PE 147.

As described above, the input feature map 130 may be input to each PE in the PEs 141 to 149 based on sequential clocks so that a multiplication-and-addition operation with a weight input based on each of the clocks is performed. An output feature map may be generated by accumulating and adding up values output through the multiplication-and-addition operation between weights and data of the input feature map 130 input in sequence.

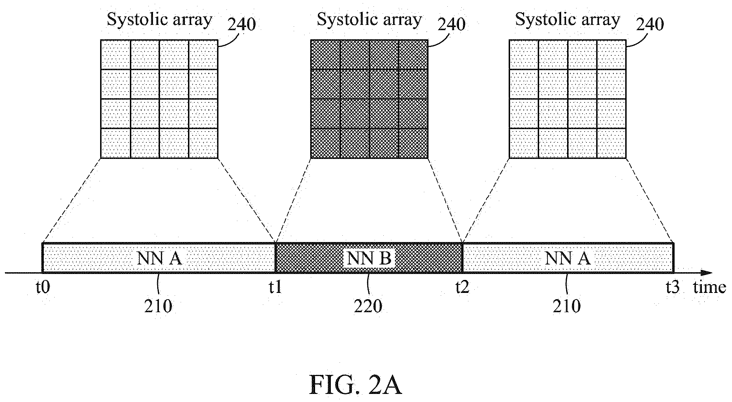

FIG. 2A is a diagram illustrating a typical method of implementing temporal multitasking based on a priority of a plurality of NNs on a systolic array.

Referring to FIG. 2A, a typical deep learning operation device may separately run a plurality of NNs using temporal multitasking of a same systolic array.

With respect to the systolic array 240, the deep learning operation device may run a NN A 210 in a first time interval from t0 to t1, perform context switching at the time t1, run a NN B 220 in a second time interval from t1 to t2, perform context switching at the time t2, and then run the NN A 210 again in a third time interval from t2 to t3. A running of a NN may correspond to the performing of a deep learning operation of the NN.

However, even if the deep learning operation device utilizes such temporal multitasking through such context switchings, it is still not possible to execute a plurality of ANNs in one systolic array at the same time. Due to characteristics of such temporal multitasking, it is previously impossible to distribute PEs of the same systolic array to a plurality of NNs, i.e., to run deep learning operations of plural NNs at the same time using the PEs of the same systolic array. Accordingly, the typical deep learning operations implemented using temporal multitasking may not achieve high throughput and NN processing per unit power (e.g., tera-operations per Watt (TOPS/Watt)) compared to the alternate typical operation in which only one NN is executed until completion before another NN is executed. Further, such a typical deep learning operation device implementing this temporal multitasking approach may not guarantee high real-time performance because a relatively large amount of time is required for each of the context switching between the NNs.

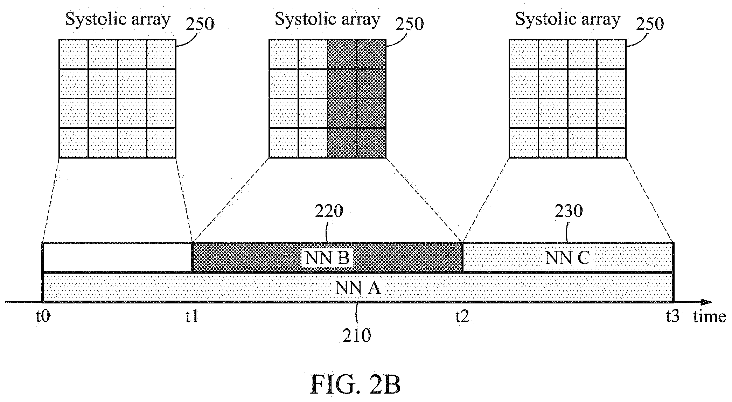

FIG. 2B is a diagram illustrating an example of an operation of a deep learning operation device that supports spatial multitasking.

Referring to FIG. 2B, a deep learning operation device may run a plurality of NNs simultaneously by distributing PEs of a systolic array 250 to the plurality of NNs through spatial multitasking. The deep learning operation device may thus run different deep learning operation tasks simultaneously, where respective NNs of the plurality of NNs may be trained to perform (e.g., having been trained, such as to perform an inference operation) and/or interimly trained for performing (e.g., currently being trained) separate tasks, where respective NN layers of one or more NNs may be trained and/or interimly trained to/for perform/performing separate tasks, and/or where respective kernels of any one or more NN layers of one or more NNs may be trained and/or interimly trained to/for perform/performing different tasks.

In this non-limiting example, the deep learning operation device may run only the NN A 210 in the first time interval from t0 to t1, then run both of the NN A 210 and the NN B 220 simultaneously in the second time interval from t1 to t2, and run the NN A 210 and a NN C 230 simultaneously in the third time interval from t2 to t3.

The deep learning operation device may run a plurality of NNs simultaneously in one systolic array, thereby improving NN's throughput and improving or guarantying real-time performance of a NN having a high priority.

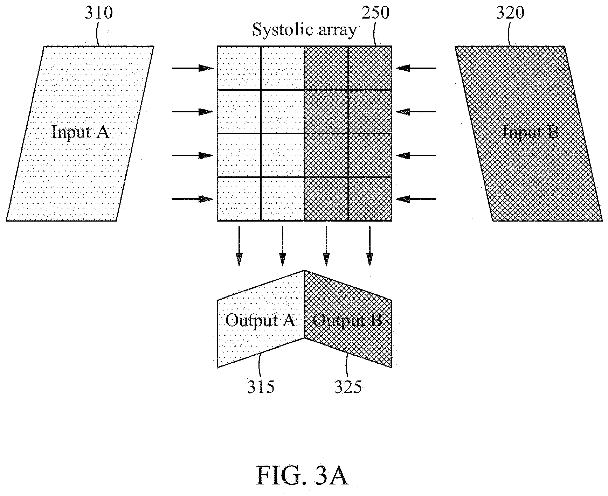

FIG. 3A is a diagram illustrating an example of a spatial multitasking operation method.

A deep learning operation device supporting spatial multitasking may distribute PEs to a plurality of NNs at a predetermined ratio of PEs, for example, based on a characteristic of the systolic array in which all of the PEs, for example, are two-dimensionally arranged.

Referring to FIG. 3A, when a NN A and a NN B are run simultaneously, input data 310 of the NN A may be input to a left side of a systolic array and input data 320 of the NN B may be input to a right side of the systolic array. The input data 310 of the NN A and the input data 320 of the NN B may be input feature map data of the NN A and input feature map data of the NN B, respectively.

The input data 310 and 320 provided at both sides of the systolic array may propagate input data horizontally based on the determined ratio at which the PEs are to be distributed to the NN A and the NN B. The respective results of each of the PEs may be propagated vertically.

For example, the input data 310 of the NN A may be propagated in a direction from left to right so that multiplication-and-addition operations, with respective weights of a filter of the NN A input to the systolic array, based on each clock is performed. In this case, output data 315 may be generated by accumulating and adding up values output through the multiplication-and-addition operations between the respective weights and the input data 310 that are input in sequence, while propagating the corresponding output values in a direction from top to bottom.

The input data 320 of the NN B may be propagated in a direction from right to left so that multiplication-and-addition operations, with respective weights of a filter of the NN B input to the systolic array, based on each clock is performed. In this case, output data 325 may be generated by accumulating and adding up values output through the multiplication-and-addition operations between the respective weights and the input data 320 that are input in sequence, while propagating the corresponding output values in a direction from top to bottom.

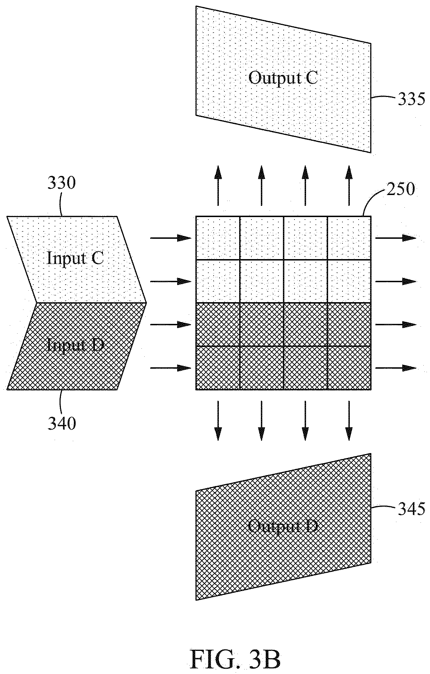

FIG. 3B is a diagram illustrating an example of a spatial multitasking operation method.

Referring to FIG. 3B, when a NN C and a NN D are executed simultaneously, input data 330 of the NN C and input data 340 of the NN D may be respectively input to a left side of a systolic array. Also, based on a determination of the ratio at which PEs are distributed, input data may be propagated horizontally, and the respective operation results may be propagated vertically.

For example, the input data 330 of the NN C may be propagated in a direction from right to left so that multiplication-and-addition operations, with respective weights of a filter of the NN C input to the systolic array, based on each clock is performed. In this case, output data 335 may be generated by accumulating and adding up values output through the multiplication-and-addition operations between the respective weights and the input data 330 that are input in sequence, while propagating the corresponding output values in a direction from bottom to top.

The input data 340 of the NN D may be propagated in a direction from left to right so that a multiplication-and-addition operation, with respective weights of a filter of the NN D input to the systolic array, based on each clock is performed. In this case, output data 345 may be generated by accumulating and adding up values output through the multiplication-and-addition operation between the respective weights and the input data 340 that are input in sequence, while propagating the corresponding output values in a direction from top to bottom.

A deep learning operation device may include a processor. The processor may determine the distribution ratio and the respective directions (e.g., vertical, horizontal) in which PEs of a systolic array are to be separated for operations of respective deep learning operation tasks, and provide corresponding input data to the systolic array based on the determined respective directions. The processor may be an neural processing unit (NPU), for example.

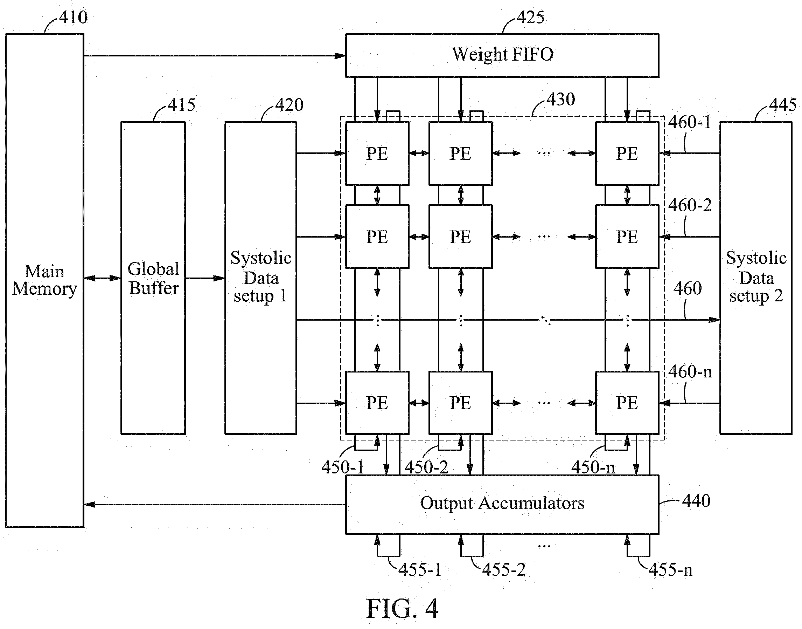

The deep learning operation device may have a structure in which each PE of the systolic array propagates input data bidirectionally, instead of unidirectionally. For this, the deep learning operation device may include a hardware unit and an on-chip network (e.g., network-on-chip (NoC)) that may be configured to horizontally propagate input data from left and right sides of the systolic array. An on-chip network may be configured to receive output data from upper and lower sides of the systolic array. Example components of such a deep learning operation device that is configured to simultaneously perform a plurality of deep learning operations are described below with greater detail with reference to FIG. 4.

FIG. 4 is a diagram illustrating an example of implementing hardware of a deep learning operation device that performs a plurality of deep learning operations simultaneously.

Referring to FIG. 4, a deep learning operation device may include a main memory 410, a global buffer 415, a first systolic data setup module 420, a weight buffer 425, a systolic array 430, and output result accumulating registers (hereinafter, referred to as "output accumulators") 440, for example.

The deep learning operation device may be a computing device configured, through hardware, to perform a neural network operation. For example, the the deep learning operation device may be a neural network device, a neural network circuit, a hardware accelerator, and a processing device, as non-limiting examples. As another example, the deep learning operation device may be, or include, various semiconductor devices such as a system on a chip (SoC), an application-specific integrated circuit (ASIC), a central processing unit (CPU), a graphics processing unit (GPU), a vision processing unit (VPU), and a neural processing unit (NPU), as non-limiting examples.

The systolic array 430 may include a plurality of PEs arranged vertically and horizontally, for example. The systolic array may be configured to perform multiple operations in accordance with a synchronization signal, for example, a clock signal. The systolic array may also be referred to as a PE array.

The systolic array 430 may receive first input data and second input data, respectively from the first systolic data setup module 420 and from the weight buffer 425, sequentially based on clock signals. The first input data may be input feature map data. The second input data may be weight(s).

The systolic array 430 may perform a deep learning operation using the input feature map data and the input weights. An operation result of the systolic array 430 may be a partial sum corresponding to an intermediate operation result for generating feature map data. The partial sum may be propagated in a predetermined direction and accumulated in the output accumulators 440.

The first systolic data setup module 420 may store data of an input feature map (e.g., the input feature map 100 of FIG. 1B). The first systolic data setup module 420 may transfer the data of the input feature map to a left side of the systolic array 430.

The weight buffer 425 may store weights of a filter (e.g., the filters 110-1 to 110-n of FIG. 1B). The weight buffer 425 may transfer the weights to an upper side of the systolic array 430.

In an example, the first systolic data setup module 420 and the weight buffer 425 may be respectively implemented using different memory devices and/or implemented in different areas of one memory device.

In one or more examples, the deep learning operation device may further include a first on-chip network, a second systolic data setup module 445, second on-chip networks 460 and 460-1 to 460-n, third on-chip networks 450-1 to 450-n, and fourth on-chip networks 455-1 to 455-n.

With such non-limiting examples, deep learning operation device may perform up, down, left, and right data propagation between PEs through the first on-chip network. Typically, deep learning operation devices perform respective data propagations between PEs only in a direction from top to bottom and from left to right. In contrast, the deep learning operation device of one or more embodiments herein may also perform data propagation between PEs through the first on-chip network in a direction from bottom to top and a direction from right to left in addition to the direction from top to bottom and the direction from left to right.

The deep learning operation device may transfer the data of the or another input feature map to a right side of the systolic array 430 through the second systolic data setup module 445, and the second on-chip networks 460 and 460-1 to 460-n. The second systolic data setup module 445 may adjust a timing for inputting input feature map data to the right side of the systolic array 430. The second on-chip networks 460 and 460-1 to 460-n may transfer the input feature map data to the right side of the systolic array 430.

The deep learning operation device may transfer the weights or other weights to a lower end of PEs included in the systolic array 430 through the third on-chip networks 450-1 to 450-n. The typical deep learning operation device can only transfer a weight to an upper end of PEs. In contrast, the deep learning operation device of one or more embodiments may also transfer the weight through the third on-chip networks 450-1 to 450-n to the lower end of the PEs in addition to the upper end.

The deep learning operation device may connect to the output accumulators 440 using the fourth on-chip networks 455-1 to 455-n. In the typical deep learning operation device, a partial sum may be propagated only to a lower side of a typical systolic array so that the propagated partial sum is transmitted to an upper end of output accumulators and accumulated therein. In contrast, in the deep learning operation device of one or more embodiments, a partial sum may also be propagated to an upper side of the systolic array 430. Thus, the deep learning operation device may transfer, to the lower end of the output accumulators 440, the partial sum propagated to the upper side of the systolic array 430 through the fourth on-chip networks 455-1 to 455-n.

The deep learning operation device may generate commands for controlling the main memory 410, the global buffer 415, the first systolic data setup module 420, the weight buffer 425, the systolic array 430, the output accumulators 440, the first on-chip network, the second systolic data setup module 445, the second on-chip networks 460 and 460-1 to 460-n, the third on-chip networks 450-1 to 450-n, and the fourth on-chip networks 455-1 to 455-n. For example, a processor may distribute the PEs to simultaneously perform deep learning operations of the example plurality of NNs based on characteristics of the plurality of NNs and set propagation directions of the input data and the partial sum.

A first input data transfer module may include the first systolic data setup module 420 and the second on-chip networks 460 and 460-1 to 460-n. A second input data transfer module may include the weight buffer 425 and the third on-chip networks 450-1 to 450-n. An output data receiving module may include the output accumulators 440 and the fourth on-chip networks 455-1 to 455-n.

In the example of FIG. 4, the components are separately configured and illustrated to describe corresponding distinguished hardware. In addition, in an example some or all of the components may be configured to be implemented by a processor or only some of the components may be configured to be implemented by the processor. In an example, a processor of the deep learning operation device may generate the commands for the above and below discussed controlling of the deep learning operation device.

The discussed and illustrated positions of the weight buffer 425, the output accumulators 440, the first systolic data setup module 420, and the second systolic data setup module 445 relative to the systolic array 430 are not limited as shown in FIG. 4, as various other configurations of the same are also available. For example, the weight buffer 425 and the output accumulators 440 may be located to the left and the right, to the right and the left, or above and below the systolic array 430. Also, the first systolic data setup module 420 and the second systolic data setup module 445 may be located above and below, below and above, or to the right and the left of the systolic array 430.

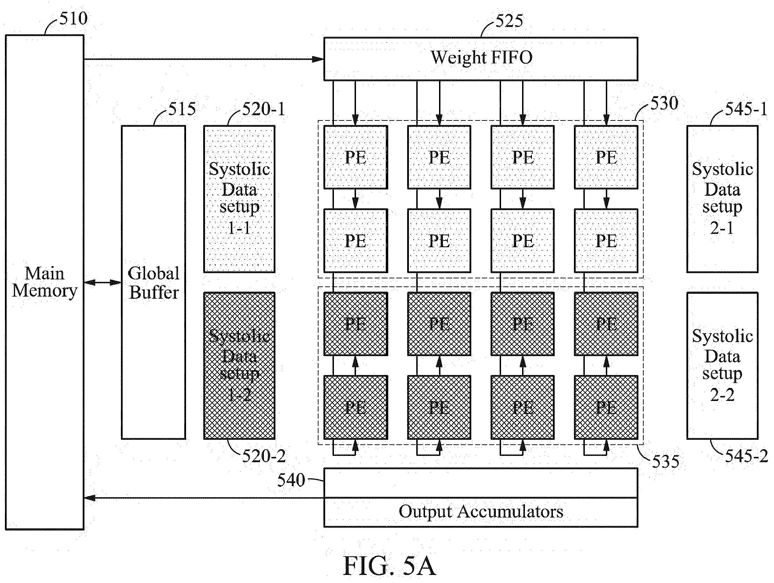

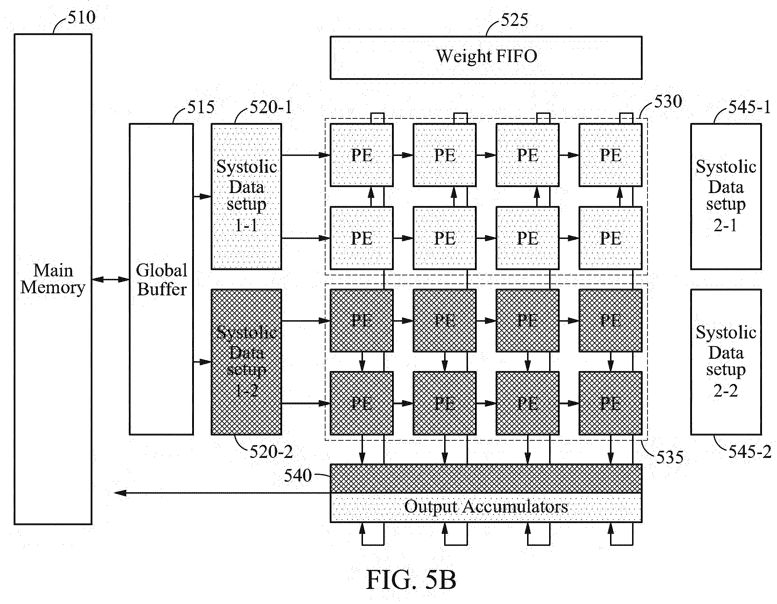

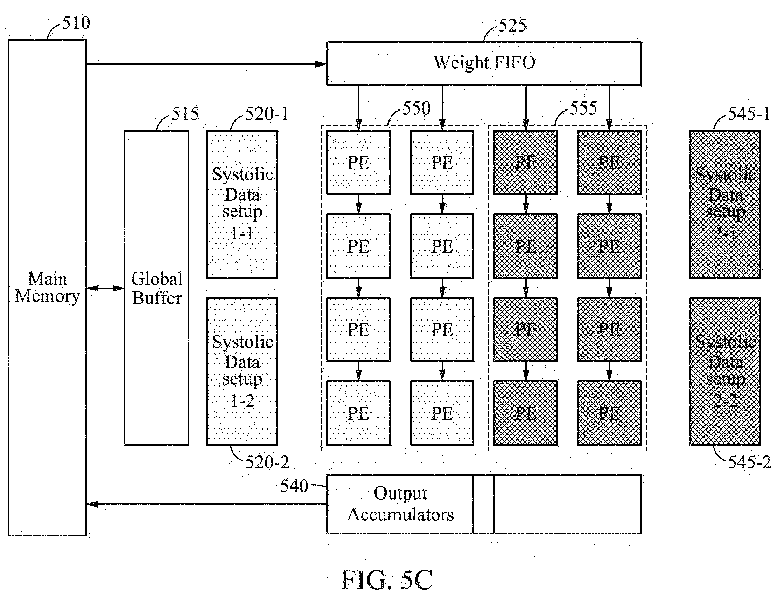

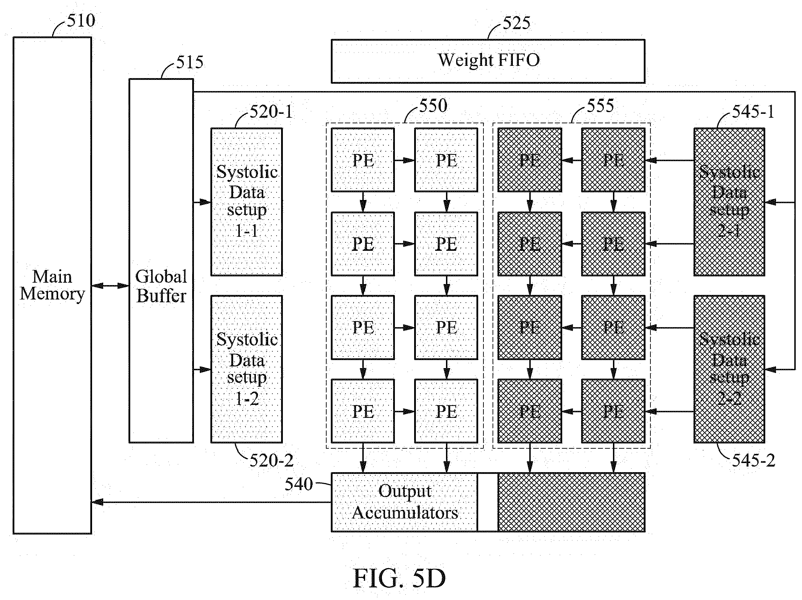

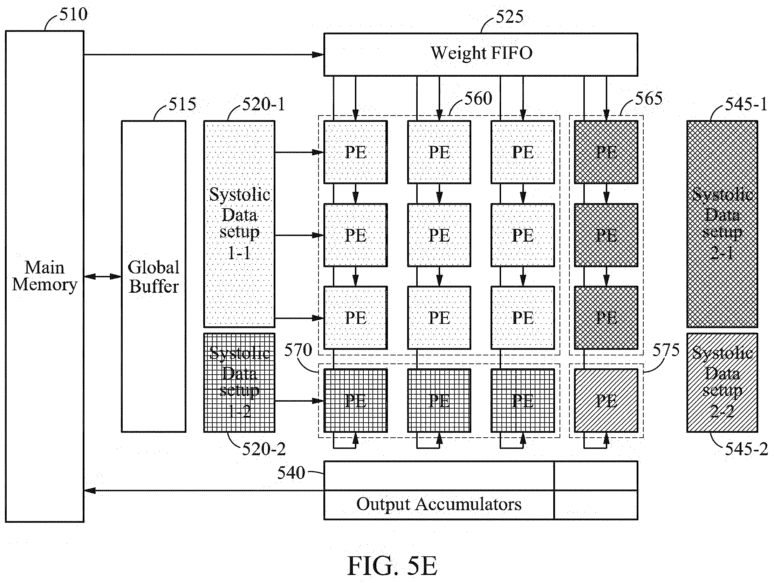

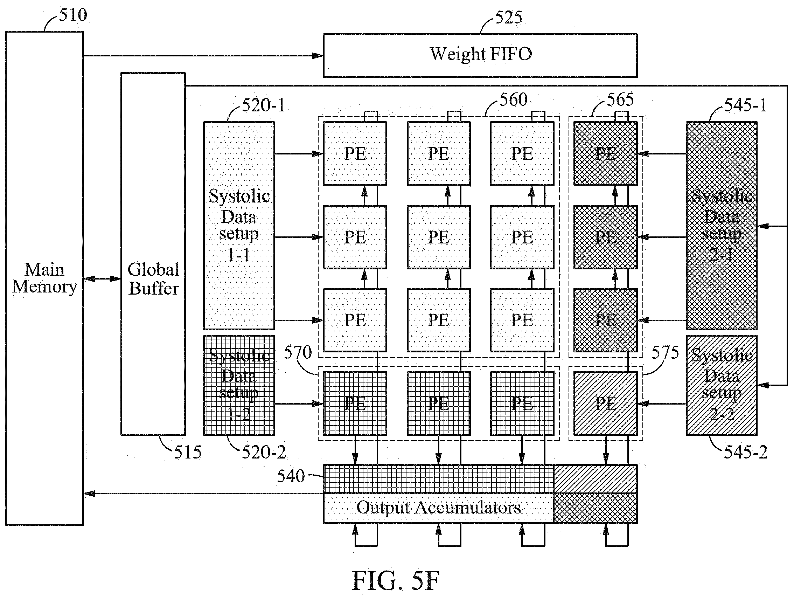

FIGS. 5A and 5B illustrate a deep learning operation device that simultaneously runs two NNs by horizontally distributing PEs of a systolic array. FIGS. 5C and 5D illustrate a deep learning operation device that simultaneously runs two NNs by vertically distributing PEs of a systolic array. FIGS. 5E and 5F illustrate a deep learning operation device that simultaneously runs four NNs by separating PEs of a systolic array into four parts. Since the descriptions of FIGS. 1A - 1D and 2B - 4 may apply to FIGS. 5A through 5F, in various examples, respective descriptions of the same content may be omitted below.

Referring to FIGS. 5A and 5B, the deep learning operation device may horizontally separate a systolic array into a first area 530 and a second area 535 to run a NN A in the first area 530 and run a NN B in the second area 535.

Referring to FIG. 5A, the deep learning operation device may propagate weights of the NN A to the first area 530 and weights of the NN B to the second area 535 in advance.

A weight buffer 525 of the deep learning operation device may receive the weights of the NN A from a main memory 510, store the received weights, and transfer the weights of the NN A to an upper end of PEs of the first area 530 based on a clock signal.

In addition, the weight buffer 525 of the deep learning operation device may receive the weights of the NN B from the main memory 510 and store the received weights. The deep learning operation device may transfer the weights of the NN B to a lower end of PEs of the second area 535 through a third on-chip network based on a clock signal.

Referring to FIG. 5B, after propagating the respective weights, the deep learning operation device may propagate input feature map data of the NN A to the first area 530 and propagate input feature map data of the NN B to the second area 535.

The above-described first systolic data setup module may include a (1-1)-th systolic data setup module 520-1 and a (1-2)-th systolic data setup module 520-2. In the drawings, the first systolic data setup module is shown separately as the (1-1)-th systolic data setup module 520-1 and the (1-2)-th systolic data setup module 520-2. However, it is intended to indicate that respective modules can be logically separated, and does not necessarily mean that the modules are physically separated components.

The (1-1)-th systolic data setup module 520-1 of the deep learning operation device may receive the input feature map data of the NN A from the main memory 510, store the received input feature map data, and transfer the input feature map data of the NN A to the left side of the first area 530 based on a clock signal. Through this, the PEs of the first area 530 may propagate the input feature map data of the NN A in a direction from left to right.

The (1-2)-th systolic data setup module 520-2 of the deep learning operation device may receive the input feature map data of the NN B from the main memory 510, store the received input feature map data, and transfer the input feature map data of the NN B to the left side of the second area 535 based on a clock signal. Through this, the PEs of the second area 535 may propagate the input feature map data of the NN B in the direction from left to right.

The PEs of the first area 530 may propagate, in a direction from bottom to top, respective partial sums obtained by performing multiplication-and-addition operations between the weights of the NN A and the input feature map data of the NN A input in sequence. The deep learning operation device may use a fourth on-chip network to transfer the respective partial sums propagated to an upper side of the first area 530 to a lower end of output accumulators 540.

The PEs of the second area 535 may propagate, in a direction from top to bottom, respective partial sums obtained by performing multiplication-and-addition operations between the weights of the NN B and the input feature map data of the NN B input in sequence. The respective partial sums propagated to a lower side of the second area 535 may be transferred to an upper end of the output accumulators 540.

Referring to FIGS. 5C and 5D, the deep learning operation device may vertically separate a systolic array into a third area 550 and a fourth area 555 to run a NN A in the third area 550 and run a NN B in the fourth area 555.

Referring to FIG. 5C, the deep learning operation device may propagate weights of the NN A to the third area 550 and weights of the NN B to the fourth area 555 in advance.

The weight buffer 525 of the deep learning operation device may receive the respective weights of the NN A and the NN B from the main memory 510 and store the received weights. Also, the weight buffer 525 may transfer the weights of the NN A to an upper end of PEs of the third area 550 and transfer the weights of the NN B to an upper end of PEs of the fourth area 555 based on a clock signal.

Referring to FIG. 5D, after propagating the respective weights, the deep learning operation device may propagate input feature map data of the NN A to the third area 550 and propagate input feature map data of the NN B to the fourth area 555.

The first systolic data setup module, for example, the (1-1)-th systolic data setup module 520-1 and the (1-2)-th systolic data setup module 520-2 of the deep learning operation device may receive the input feature map data of the NN A from the main memory 510, store the input feature map data, and transfer the input feature map data of the NN A to a left side of the third area 550 based on a clock signal. Through this, the PEs of the third area 550 may propagate the input feature map data of the NN A in the direction from left to right.

A second systolic data setup module of the deep learning operation device may receive the input feature map data of the NN B from the main memory 510 and store the received input feature map data. Like the first systolic data setup module, the second systolic data setup module may include a (2-1)-th systolic data setup module 545-1 and a (2-2)-th systolic data setup module 545-2. The second systolic data setup module is illustrated separately as the (2-1)-th systolic data setup module 545-1 and the (2-2)-th systolic data setup module 545-2. However, this illustrated separation is intended to indicate that respective modules are logically separated, and does not necessarily mean that the modules are physically separated components.

The deep learning operation device may use a second on-chip network to input the input feature map data of the NN B to a right side of the fourth area 555. Through this, PEs of the fourth area 555 may propagate the input feature map data of the NN B in a direction from right to left.

The PEs of the third area 550 may propagate, in a direction from bottom to top, respective partial sums obtained by performing multiplication-and-addition operations between the weights of the NN A and the input feature map data of the NN A input in sequence.

The PEs of the fourth area 555 may propagate, in a direction from top to bottom, respective partial sums obtained by performing multiplication-and-addition operations between the weights of the NN B and the input feature map data of the NN B input in sequence. The respective partial sums propagated to a lower side of the fourth area 555 may be transferred to the upper end of the output accumulators 540.

Referring to FIGS. 5E and 5F, the deep learning operation device may separate a systolic array into four areas, for example, a fifth area 560, a sixth area 565, a seventh area 570, and an eighth area 575 to run a NN A in the fifth area 560, run a NN B in the sixth area 565, run a NN C in the seventh area 570, and run a NN D in the eighth area 575.

Referring to FIG. 5E, the deep learning operation device may propagate weights of the NN A to the fifth area 560, weights of the NN B to the sixth area 565, weights of the NN C to the seventh area 570, and weights of the NN D to the eighth area 575 in advance.

The weight buffer 525 of the deep learning operation device may receive the respective weights of the NN A and the NN B from the main memory 510, store the received weights, and transfer the respective weights of the NN A and the NN B to an upper end of PEs of the fifth area 560 and an upper end of PEs of the sixth area 565 based on a clock signal.

In addition, the weight buffer 525 of the deep learning operation device may receive the respective weights of the NN C and the NN D from the main memory 510 and store the received weights. The deep learning operation device may transfer the respective weights of the NN C and the NN D to lower ends of PEs of the seventh area 570 and the eighth area 575 through the third on-chip network based on a clock signal.

Referring to FIG. 5F, after propagating the weights, the deep learning operation device may propagate the input feature map data of the NN A to the fifth area 560, the input feature map data of the NN B to the sixth area 565, input feature map data of the NN C to the seventh area 570, and input feature map data of the NN D to the eighth area 575.

The (1-1)-th systolic data setup module 520-1 of the deep learning operation device may receive the input feature map data of the NN A from the main memory 510, store the received input feature map data, and transfer the input feature map data of the NN A to a left side of the fifth area 560 based on a clock signal. Through this, the PEs of the fifth area 560 may propagate the input feature map data of the NN A in the direction from left to right.

The (1-2)-th systolic data setup module 520-2 of the deep learning operation device may receive the input feature map data of the NN C from the main memory 510, store the received input feature map data, and transfer the input feature map data of the NN C to a left side of the seventh area 570 based on a clock signal. Through this, the PEs of the seventh area 570 may propagate the input feature map data of the NN C in the direction from left to right.

The (2-1)-th systolic data setup module 545-1 of the deep learning operation device may receive the input feature map data of the NN B from the main memory 510 and store the received input feature map data. The deep learning operation device may input the input feature map data of the NN B to a right side of the sixth area 565 using a second on-chip network. Through this, the PEs of the sixth area 565 may propagate the input feature map data of the NN B in the direction from right to left.

The (2-2)-th systolic data setup module 545-2 of the deep learning operation device may receive the input feature map data of the NN D from the main memory 510 and store the received input feature map data. The deep learning operation device may input the input feature map data of the NN D to a right side of the eighth area 575 using the second on-chip network. Through this, the PEs of the eighth area 575 may propagate the input feature map data of the NN D in the direction from right to left.

The PEs of the fifth area 560 may propagate, in the direction from bottom to top, respective partial sums obtained by performing multiplication-and-addition operations between the weights of the NN A and the input feature map data of the NN A input in sequence. The deep learning operation device may use the fourth on-chip network to transfer the respective partial sums propagated to an upper side of the fifth area 560 to a left lower end of the output accumulators 540.

The PEs of the seventh area 570 may propagate, in the direction from top to bottom, respective partial sums obtained by performing multiplication-and-addition operations between the weights of the NN C and the input feature map data of the NN C input in sequence. The respective partial sums propagated to a lower side of the seventh area 570 may be transferred to a left upper end of the output accumulators 540.

The PEs of the sixth area 565 may propagate, in the direction from bottom to top, respective partial sums obtained by performing multiplication-and-addition operations between the weights of the NN B and the input feature map data of the NN B input in sequence. The deep learning operation device may use a fourth on-chip network to transfer the respective partial sums propagated to an upper side of the sixth area 565 to a right lower end of the output accumulators 540.

The PEs of the eighth area 575 may propagate, in the direction from top to bottom, respective partial sums obtained by performing multiplication-and-addition operations between the weights of the NN D and the input feature map data of the NN D input in sequence. The respective partial sums propagated to a lower side of the eighth area 575 may be transferred to a right upper end of the output accumulators 540.

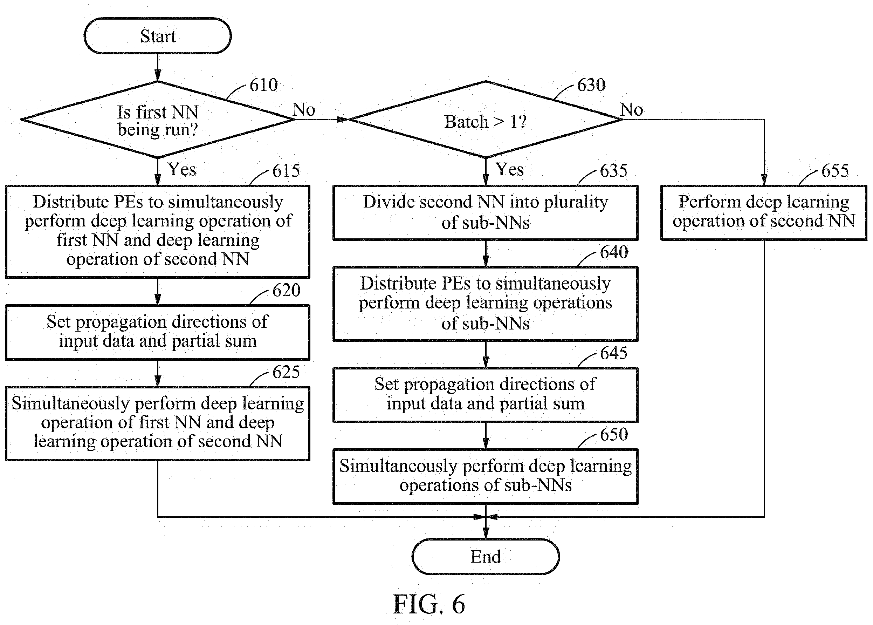

FIG. 6 is a flowchart illustrating a method of performing deep learning operations through spatial multitasking.

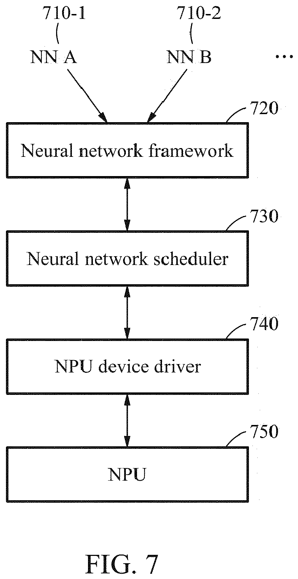

Referring to FIG. 6, operations 610 through 655 may be performed by any one, any combination, or all of the deep learning operation devices described with reference to FIGS. 1A - 1D, 2B - 5F above, and FIG. 7 below.

In operation 610, the deep learning operation device may determine whether a first NN being run is present.

In operation 615, when the first NN being run is determined to be present, the deep learning operation device may distribute PEs to simultaneously perform a deep learning operation of the first NN and a deep learning operation of a second NN based on a characteristic of the first NN and a characteristic of the second NN. The second NN may be a NN newly received or determined/scheduled to be run.

The deep learning operation device may determine a distribution method and a distribution ratio of the PEs based on the characteristic of the first NN and the characteristic of the second NN. A characteristic of a NN may include, for example, the number of NN layers, the input for each layer, the weights, and the size of output data.

The deep learning operation device may secure PEs by preempting the deep learning operation of the first NN based on the distribution method and the distribution ratio and allocate the PEs secured through the preempting to the deep learning operation of the second NN.

In operation 620, the deep learning operation device may set propagation directions of respective input data and respective partial sums based on the characteristic of the first NN and the characteristic of the second NN. The deep learning operation device may set whether the input data of the first NN and the second NN is to be propagated in a leftward direction or a rightward direction and set whether the corresponding partial sums are to be propagated in an upward direction or a downward direction.

In operation 625, the deep learning operation device may simultaneously perform the deep learning operation of the first NN and the deep learning operation of the second NN using the distributed PEs.

When the first NN being run is then determined or scheduled to be absent, the deep learning operation device may run the second NN using all PEs of the systolic array.

Further, to improve NN throughput and TOPS/Watt, the deep learning operation device may divide one NN into a plurality of sub-NNs and run the sub-NNs simultaneously, even in a case in which NN is run by itself.

In operation 630, the deep learning operation device may determine whether the second NN has a plurality of batches.

In operation 635, when the second NN has the plurality of batches (for example, when image recognition is to be performed on multiple images), the deep learning operation device may divide the second NN into a plurality of sub-NNs. For example, the deep learning operation device may divide the second NN into two sub-NNs having batches in half.

In operation 640, the deep learning operation device may distribute PEs to simultaneously perform deep learning operations of the sub-NNs based on characteristics of the sub-NNs.

In operation 645, the deep learning operation device may set propagation directions of input data and respective partial sums based on the characteristics of the sub-NNs. For example, the deep learning operation device may equally distribute the PEs of the systolic array to two sub-NNs.

In operation 650, the deep learning operation device may simultaneously perform the deep learning operations of the sub-NNs using the distributed PEs.

A method of dividing one NN into a plurality of sub-NNs and running the sub-NNs simultaneously may be effectively used when sizes or shapes of various layers constituting the NN are drastic. For example, in terms of a weight-stationary NPU, if the number of output channels is less than a length of a horizontal side of a PE, computational resources may not be fully utilized. According to a method of running the sub-NNs simultaneously, in a case in which PEs are not fully utilized as in the example above, it is possible to achieve higher performance by dividing one NN into a plurality of sub-NNs and running the sub-NNs simultaneously when compared to a typical approach in which only one NN can be run. Another such example of the use of the dividing of the NN into the plurality of sub-NNs may be effectively used when the sizes or shapes of the various layers are drastic due to different trained tasks of the different layers. Also, corresponding to discussion of FIG. 2B with reference to simultaneously performed deep learning operations, separate kernel operations may be considered sub-NNs.

In operation 655, when the second NN has one batch, the deep learning operation device may run the second NN using all PEs of the systolic array.

FIG. 7 is a diagram illustrating an example of a method of utilizing an NPU for spatial multitasking.

Referring to FIG. 7, a deep learning operation device may simultaneously run a plurality of NNs, for example, a NN A 710-1 and a NN B 710-2 in a multi-user environment such as a server or desktop with an NPU for spatial multitasking.

The plurality of NNs may make a request for utilization of the NPU through a neural network framework 720 such as TensorFlow and PyTorch. The request may be forwarded to lower-level software, a neural network scheduler 730.

A typical NPU does not support spatial multitasking. Thus, after a command to run one NN is sent to the typical NPU, a request for running a subsequent NN may not be sent to the typical NPU until the running of the typical NPU for the one NN has been completed.

In contrast, the deep learning operation device of various embodiments may simultaneously run numerous NNs for spatial multitasking. Thus, the neural network scheduler 730 considering spatial multitasking may forward a command to run a plurality NNs to an NPU. In this instance, since an NPU 750 is hardware and the neural network scheduler 730 is software executed by a processor of the deep learning operation device, NN running commands may be forwarded through an NPU device driver 740 that enables communication between the neural network scheduler 730 and the NPU 750.

In the deep learning operation device, the NPU 750 supporting spatial multitasking may simultaneously run a plurality of NNs for which the neural network scheduler 730 considering the spatial multitasking has sent a command for running. The plurality of run NNs may include NNs involving inferential operations as well as training operations, and thus,

The processors, the deep learning operation devices, processing elements (PEs), systolic arrays, main memory, global buffer, systolic data setups, weight FIFOs, output accumulators, neural network frameworks, neural network schedulers, NPU device drivers, NPUs, input data transfer modules, systolic data setup modules, output data receiving modules, and other apparatuses, modules, devices, and other components described herein with respect to FIGS. 1A - 1D and 2B - 7 are implemented by hardware components. Examples of hardware components that may be used to perform the operations described in this application where appropriate include controllers, sensors, generators, drivers, memories, comparators, systolic arrays and the like, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers, e.g., in cooperation with one or more systolic arrays as non-limiting examples. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. A hardware component may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods of FIGS. 1A - 1D and 2B - 7 that perform the operations described in this application are performed by computing hardware, for example, by one or more processors or computers, implemented as described above executing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, as well as one or more systolic arrays in combination therewith as a non-limiting example, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions used herein, which disclose algorithms for performing the operations that are performed by the hardware components and the methods as described above.

The instructions or software to control computing hardware, for example, one or more processors or computers, as well as one or more systolic arrays in combination therewith, to implement the hardware components and perform the methods as described above, and any associated data, data files, and data structures, may be recorded, stored, or fixed in or on one or more non-transitory computer-readable storage media. Examples of a non-transitory computer-readable storage medium include read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD-Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

## Claims

1. An electronic device, comprising:
a processor configured to simultaneously perform, using a systolic array, a plurality of tasks,
wherein the processor comprises:
the systolic array comprising a plurality of processing elements, PEs; and
a first on-chip network that performs data propagation between two or more of the plurality of PEs, and
wherein each of the plurality of tasks includes one or more deep learning operations.

2. The electronic device of claim 1, wherein the processor is configured to distribute the plurality of PEs to simultaneously perform respective deep learning operations of a plurality of neural networks, NNs, where the distribution of the plurality of PEs is performed based on characteristics of the plurality of NNs, and wherein the distribution of the plurality of PEs includes a distribution of all PEs of the systolic array, or
wherein the processor is configured to set, based on characteristics of a plurality of NNs, respective propagation directions of input data and corresponding output partial sums, or
wherein the processor is configured to divide a NN into a plurality of sub-NNs and distribute the plurality of PEs so as to simultaneously perform deep learning operations of the sub-NNs, and to set respective propagation directions of input data and corresponding output partial sums based on characteristics of the sub-NNs.

3. The electronic device of claim 1 or 2, wherein the processor further comprises:
an input data transfer module configured to input data to different sides of the systolic array.

4. The electronic device of claim 3,
wherein the different sides of the systolic array are opposing left and right sides of the systolic array, and
wherein the input data transfer module comprises:
a first systolic data setup module configured to adjust a timing for inputting first input data to the left side of the systolic array and transfer first input data to the left side of the systolic array;
a second systolic data setup module configured to adjust a timing for inputting second input data to the right side of the systolic array; and
a second on-chip network configured to transfer the second input data to the right side of the systolic array.

5. The electronic device of claim 3 or 4, wherein the different sides of the systolic array are opposing left and right sides of the systolic array, where first input data is input using the first on-chip network and second input data is input using a second-one-chip network, and
wherein the processor further comprises another input data transfer module configured to input weight input data to upper and lower sides of the systolic array, wherein the other input data transfer module comprises:
a weight buffer configured to adjust a timing for inputting first weight input data and second weight input data to the systolic array, and to transfer the first weight input data to respective first PEs through the upper side of the systolic array; and
a third on-chip network configured to transfer the second weight input data to respective second PEs, of the plurality of PEs, through the lower side of the systolic array.

6. The electronic device of one of claims 1 to 5, wherein the processor further comprises:
an input data transfer module configured to input input data to upper and lower ends of respective PEs of the plurality of PEs.

7. The electronic device of claim 6,
wherein the input data transfer module comprises:
a weight buffer configured to adjust a timing for inputting at least first weight input data to first PEs, of the plurality of PEs, and transfer the first weight input data to upper ends of the first PEs; and
another on-chip network configured to transfer second weight input data to lower ends of second PEs of the plurality of PEs.

8. The electronic device of claim 7, wherein the weight buffer is configured to adjust the timing for inputting the second weight input data to the second PEs, or
wherein the output data receiving module comprises output accumulators; and another on-chip network configured to transfer corresponding output partial sums propagated to the upper side of the systolic array to a lower end of the output accumulators, and transfer corresponding output partial sums propagated to the lower side of the systolic array to an upper end of the output accumulators.

9. The electronic device of one of claims 1 to 8, wherein the processor further comprises:
an output data receiving module configured to receive output data corresponding to a result of an operation, between first input data and second input data, from upper and lower sides of the systolic array.

10. The electronic device of one of claims 1 to 9, wherein the division of the NN into the plurality of sub-NNs is performed according to respective tasks of different layers of the NN, or
wherein the division of the NN into the plurality of sub-NNs is performed according to different batches of the NN, or
wherein the processor is configured to set respective propagation directions of input data and corresponding output partial sums for the multiple PEs based on characteristics of the two or more sub-NNs, and wherein the distribution of the multiple PEs comprises determining a distribution method and a distribution ratio of the multiple PEs based on the characteristics of the sub-NNs, or
wherein the processor is further configured to perform a deep learning operation of another NN, using other PEs of the plurality of PEs, simultaneously with the deep learning operations of the two or more of the sub-NNs performed using the multiple PEs.

11. A processor-implemented method, the method comprising:
determining whether a first neural network, NN, is presently being run by a processor; and
in response to the first NN being determined to be presently run by the processor:
distributing a plurality of processing units, Pes, to simultaneously perform a deep learning operation of the first NN and a deep learning operation of a second NN based on a characteristic of the first NN and a characteristic of the second NN, wherein the second NN is a NN newly set to be run by the processor;
setting respective propagation directions of input data and corresponding output partial sums based on the characteristic of the first NN and the characteristic of the second NN; and
simultaneously performing the deep learning operation of the first NN and the deep learning operation of the second NN using the distributed plurality of PEs.

12. The method of claim 11, wherein the distributing of the plurality of PEs comprises determining a distribution method and a distribution ratio of the plurality of PEs based on the characteristic of the first NN and the characteristic of the second NN,
wherein the distributing of the plurality of PEs comprises preempting a presently run deep learning operation of the first NN based on the distribution method and the distribution ratio; and implementing the distributing of the plurality of processing units, Pes, by allocating multiple PEs, of the plurality of PEs, secured through the preempting to perform the deep learning operation of the second NN, and allocating another multiple PEs, of the plurality of PEs, secured through the preempting to perform the deep learning operation of the first NN, and
wherein the plurality of PEs are PEs of a systolic array.

13. The method of claim 11 or 12, further comprising:
determining, in a case in which the first NN is not presently being run by the processor, whether the second NN has a plurality of batches; and
in response to the second NN being determined to have the plurality of batches:
dividing the second NN into a plurality of sub-NNs;
distributing multiple PEs, of the plurality of PEs, to simultaneously perform deep learning operations of the sub-NNs based on characteristics of the sub-NNs;
setting respective propagation directions of input data and corresponding output partial sums based on the characteristics of the sub-NNs; and
simultaneously performing respective deep learning operations of the sub-NNs using the distributed multiple PEs,
wherein the distributing of the multiple PEs comprises:
determining a distribution method and a distribution ratio of the multiple PEs based on the characteristics of the sub-NNs.

14. The method of one of claims 11 to 13, further comprising:
dividing the second NN into a plurality of sub-NNs according to respective batches of the second NN;
distributing multiple PEs, of the plurality of PEs, to simultaneously perform deep learning operations of the sub-NNs based on characteristics of the sub-NNs;
setting respective propagation directions for input data of the multiple PEs and for output partial sums of the multiple PEs based on the characteristics of the sub-NNs; and
simultaneously performing respective deep learning operations of the first NN and deep learning operations of the sub-NNs using the distributed multiple PEs.

15. A computer-readable recording medium comprising instructions, which when executed by processing hardware, configures the processing hardware to implement the method of one of claims 11 to 14.
